# EUROPEAN PATENT APPLICATION

(11) **EP 2 048 716 A2**
(43) Date of publication of application: **15.04.2009**
(21) Application number: 08166127.4
(22) Date of filing: 08.10.2008
(51) Int. Cl.: H01L 31/18

(54) **A process of phosphorus diffusion for manufacturing solar cell**

(30) Priority: 08.10.2007 CN 200710132841; 01.10.2008 EP 08165604
(71) Applicant: CSI Cells Co. Ltd., Suzhou New District Suzhou Jiangsu 215-123 (CN)
(72) Inventor: Zhang, Lingjun, 215123, Suzhou (CN); Zuo, Yunxiang, 215123, Suzhou (CN)
(74) Representative: Lermer, Christoph

(57) **Abstract**

This invention discloses a process of phosphorus diffusion for manufacturing solar cell, comprising: (1) annealing the mono-crystalline silicon wafer in a nitrogen atmosphere at 900∼950 °C for 20 to 30 minutes; (2) carrying oxidation treatment in a hydrogen chloride atmosphere at 850 ∼ 1050 °C to form a 10 to 30 nm thick oxide layer on the surface of said silicon wafer; (3) then diffusing from a phosphorus source at 850 ∼ 900 °C, till the block resistance of material surface is controlled at 40 to 50 ohms, and the junction depth is at 0.2 to 1.0 microns; (4) finally, annealing in a nitrogen atmosphere at 700∼750 °C for 30 to 60 minutes to complete the phosphorus diffusion of said mono-crystalline silicon wafer. This invention can use 4N ∼ 5N mono-crystalline silicon as the material for manufacturing solar cells, so, the low purity material such as metallurgical silicon could be used, which has greatly reduced the cost of materials and is conducive to put the mono-crystalline silicon solar cells into universal application.

## Description

### Technical Field

This invention relates to a process to make junction for manufacturing solar cell by diffusion, and more particularly to a process of phosphorus diffusion for manufacturing solar cell.

### Background of the invention

Solar energy is an inexhaustible and renewable energy source for mankind, and also a clean energy, so utilization of solar energy can effectively reduce environmental pollution. The use of photoelectric effect of solar is a researching field that is the fastest growing and most dynamic one in recent years. Solar cells are manufactured mainly based on semiconductor materials, and its working principle is that the photoelectric materials absorb solar energy and produce electricity currents through photoelectric conversion. Silicon solar cells are widely used nowadays. Silicon solar cells are classified into mono-crystalline silicon cells, amorphous silicon solar cells, poly-silicon solar cells and so on. Among them, mono-crystalline silicon solar cells have the highest conversion efficiency and are most mature in technology.

In previous art, method for manufacturing mono-crystalline silicon solar cells includes the following steps: peeling off the affected layer etching → diffusion and junction making → plasma etching of edge → removing phosphorus glass → anti-reflection coating → screen printing → sintering. The diffusion and junction making (usually phosphorus diffusion and junction making) is a key step, and the quality of this step will affect the photoelectric conversion efficiency. In commercial process, the typical steps of junction making are: first, have the nitrogen go through liquid POCl₃, transfer the impurity for doping onto the surface of high-temperature semiconductor by using carrier gas, and the depth of diffusion of impurities is about hundreds of nanometer; the second step is high temperature treatment so that the impurity atoms pre-deposited on the surface continue to diffuse into deep base and thus forms a N⁺ / N layer, such a structure is conducive making the electrode in subsequent steps. Such emission zone structure can also be obtained with one step diffusion method, but it need to add a corrosion process; fast heating process can also be used for said junction making, which can greatly simplify the process, but this process has only at an early stage.

However, the above diffusion and junction making process is based on the use of high quality mono-crystalline silicon, which is usually required to have a purity of more than 6N. But the more the purity, the more expensive the material cost, which makes the price of mono-crystalline silicon solar cell remain high and is hard to put into universal application. At the same time, by using raw materials of metallic silicon with low purity as a starting material, after melting and refining, unidirectional solidification refining, and so on, the purity can reach 4N ~ 5N, but if further purify the material to get more than 6N high-purity silicon, it would greatly increase the cost, and also reduce the utilization of silicon. Therefore, the development of a phosphorus diffusion method to directly use 4N ~ 5N low-purity silicon material to make solar cells with better conversion efficiency will have great significance.

### Contents of the invention

The object of the present invention is to provide a process of phosphorus diffusion for manufacturing solar cell, so that we can use a lower purity material to produce silicon solar cells.

This object is achieved according to the technical solution described below: a process of phosphorus diffusion for manufacturing solar cell, comprising:
(1) annealing the mono-crystalline silicon wafer in a nitrogen atmosphere at 900∼950 °C for 20 to 30 minutes;
(2) carrying oxidation treatment in a hydrogen chloride atmosphere at 850 - 1050 °C to form a 10 to 30 nm thick oxide layer on the surface of said silicon wafer;
(3) diffusing from a phosphorus source at 850 - 900 °C, till the block resistance of material surface is controlled at 40 to 50 ohms, and the junction depth is at 0.2 to 1.0 microns;
(4) finally, annealing in a nitrogen atmosphere at 700-750 °C for 30 to 60 minutes to complete the phosphorus diffusion of said mono-crystalline silicon wafer.

In the above mentioned technical solution, the duration of said oxidation treatment in step (2) is 20 to 30 minutes.

The duration for said diffusion from a phosphorus source in step (3) is 25 to 60 minutes.

In the mono-crystalline silicon wafer, heavy metals or micro-defects will move or re-agglutinate at a certain temperature because the interaction between impurities and impurities as well as defects and impurities. Thus, through the annealing process, the impurities in the wafer will become nanometer-sized spots and thereby reduces the density defect recombination centers to raise minority carrier lifetime. However, in the conventional technologies, annealing process would usually take 4 to 5 hours, and the temperature should change from low to high and then to low, which, when used to deal with the mono-crystalline silicon with 4N∼5N purity, is difficult to achieve good result of removing impurities and getting good junction effect. In this invention, the oxidation treatment in a hydrogen chloride atmosphere is added between the steps of annealing and phosphorus diffusion, that is, using the chlorine oxidization method to make oxide layer, thus, in the entire process, the temperature changes from high to low then to high and then to low, which is a gradual changing course. The actual tests show that using this method can obtain good results.

With using of the above technical solution, this invention has the following effects compared with the background technologies:
In this invention, there are two steps of annealing both before and after the process of phosphorus diffusion to make the impurities in the wafer become nanometer-sized spots and thereby reduces the density defect recombination centers to raise minority carrier lifetime. And the oxidation treatment in a hydrogen chloride atmosphere is added between the steps of annealing and phosphorus diffusion. After said treatment, this invention can use 4N - 5N low-purity mono-crystalline silicon as the material for manufacturing solar cells, which has greatly reduced the cost of materials and is conducive to put the mono-crystalline silicon solar cells into universal application.

### Description of example embodiments

This invention will be best understood with reference to the following description of example embodiments:

### Example 1:

Conduct the following phosphorus diffusion process with a set of silicon wafers with 5N purity: step 1: put the silicon wafer in a nitrogen atmosphere for annealing at 950 °C for 20 minutes; step 2: put the silicon wafer in a hydrogen chloride atmosphere for an oxidation treatment at 850 °C for 20 minutes; step 3: conduct phosphorus diffusion process on the silicon wafer at 900 °C for 50 minutes; step 4: put the silicon wafer in a nitrogen atmosphere at 750 °C for 30 minutes. Then use conventional methods for further processing. Thus solar cells are produced.

Ten (10) of said solar cells are randomly selected, the short circuit current Isc, open circuit voltage Voc, the maximum power Pmax, fill factor FF and photoelectric conversion efficiency EF are measured under conditions of AM1.5 and a temperature of 27 °C. The results are as shown in the table below:

| **No.** | **Isc(A)** | **Voc(mV)** | **Pmax(W)** | **FF(%)** | **EF(%)** |
|---|---|---|---|---|---|
| **1** | **4.46644** | **610.52** | **1.73559** | **63.648** | **11.68116** |
| **2** | **4.54678** | **613.26** | **2.17556** | **77.882** | **14.61594** |
| **3** | **4.53085** | **613.22** | **2.09676** | **78.303** | **14.64234** |
| **4** | **4.49747** | **610.76** | **1.85691** | **76.332** | **14.11197** |
| **5** | **4.38281** | **607.12** | **2.07611** | **69.785** | **12.49769** |
| **6** | **4.44712** | **609.22** | **2.05781** | **76.629** | **13.97298** |
| **7** | **4.42516** | **608.7** | **2.09916** | **76.396** | **13.84986** |
| **8** | **4.43123** | **608.15** | **2.09444** | **77.895** | **14.12916** |
| **9** | **4.46954** | **608.6** | **2.09446** | **76.994** | **14.09635** |
| **10** | **4.50129** | **612.25** | **2.10562** | **76.404** | **14.17161** |
| **Average** | **4.469869** | **610.18** | **2.039242** | **75.0268** | **13.77691** |

### Example 2:

Conduct the following phosphorus diffusion process with another set of silicon wafers with 5N purity: step 1: put the silicon wafer in a nitrogen atmosphere for annealing at 950 °C for 25 minutes; step 2: put the silicon wafer in a hydrogen chloride atmosphere for an oxidation treatment at 1000 °C for 25 minutes; step 3: conduct phosphorus diffusion process on the silicon wafer at 900 °C for 30 minutes; step 4: put the silicon wafer in a nitrogen atmosphere at 700 °C for 50 minutes. Then use conventional methods for further processing. Thus solar cells are produced.

Ten (10) of said solar cells are randomly selected, the short circuit current Isc, open circuit voltage Voc, the maximum power Pmax, fill factor FF and photoelectric conversion efficiency EF are measured under conditions of AM1.5 and a temperature of 27 °C. The results are as shown in the table below:

| **No.** | **Isc(A)** | **Voc(mV)** | **Pmax(W)** | **FF(%)** | **EF(%)** |
|---|---|---|---|---|---|
| **1** | **4.35766** | **609.14** | **2.04992** | **77.226** | **13.79673** |
| **2** | **4.4196** | **610.17** | **2.09707** | **77.773** | **14.11409** |
| **3** | **4.39372** | **607.99** | **2.07775** | **77.78** | **13.98408** |
| **4** | **4.3689** | **608.53** | **2.06782** | **77.778** | **13.91723** |
| **5** | **4.37946** | **608.45** | **2.05224** | **77.017** | **13.81236** |
| **6** | **4.44184** | **612.49** | **2.13835** | **78.599** | **14.39191** |
| **7** | **4.40191** | **608.81** | **1.71494** | **63.991** | **11.54202** |
| **8** | **4.45567** | **612.57** | **2.10022** | **76.947** | **14.13526** |
| **9** | **4.42383** | **613.46** | **2.10247** | **77.472** | **14.15045** |
| **10** | **4.27499** | **605.99** | **1.78353** | **68.847** | **12.00382** |
| **Average** | **4.391758** | **609.76** | **2.044531** | **75.343** | **13.5848** |

### Example 3:

Conduct the following phosphorus diffusion process with another set of silicon wafers with 5N purity: step 1: put the silicon wafer in a nitrogen atmosphere for annealing at 920 °C for 30 minutes; step 2: put the silicon wafer in a hydrogen chloride atmosphere for an a oxidation treatment at 950 °C for 30 minutes; step 3: conduct phosphorus diffusion process on the silicon wafer at 850 °C for 60 minutes; step 4: put the silicon wafer in a nitrogen atmosphere at 700 °C for 40 minutes. Then use conventional methods for further processing. Thus solar cells are produced.

Sixteen (16) of said solar cells are randomly selected, the short circuit current Isc, open circuit voltage Voc, the maximum power Pmax, fill factor FF and photoelectric conversion efficiency EF are measured under conditions of AM1.5 and a temperature of 28 °C. The results are as shown in the table below:

| **No.** | **Isc(A)** | **Voc(mV)** | **Pmax(W)** | **FF(%)** | **EF(%)** |
|---|---|---|---|---|---|
| **1** | **4.40454** | **607.89** | **2.00977** | **75.063** | **13.52651** |
| **2** | **4.43724** | **609.05** | **2.04521** | **75.678** | **13.76501** |
| **3** | **4.42288** | **609.12** | **2.09828** | **77.885** | **14.12223** |
| **4** | **4.4701** | **609.89** | **2.08441** | **76.456** | **14.0289** |
| **5** | **4.46758** | **609.76** | **2.08204** | **76.428** | **14.0129** |
| **6** | **4.51984** | **611.04** | **2.10364** | **76.169** | **14.15827** |
| **7** | **4.43159** | **606.86** | **2.07638** | **77.207** | **13.97485** |
| **8** | **4.54037** | **609.98** | **2.12963** | **76.895** | **14.3332** |
| **9** | **4.49947** | **608.79** | **2.0755** | **75.769** | **13.96892** |
| **10** | **4.52432** | **610.23** | **2.11063** | **76.449** | **14.20537** |
| **11** | **4.4557** | **609.58** | **2.02947** | **74.719** | **13.65908** |
| **12** | **4.50928** | **607.72** | **2.01459** | **73.515** | **13.55895** |
| **13** | **4.55504** | **610.54** | **2.14621** | **77.173** | **14.44481** |
| **14** | **4.51071** | **610.46** | **2.08132** | **75.585** | **14.00807** |
| **15** | **4.51885** | **611.89** | **2.0619** | **74.571** | **13.87738** |
| **16** | **4.49353** | **609.17** | **2.07788** | **75.909** | **13.98492** |
| **Average** | **4.485065** | **609.4981** | **2.076679** | **75.96694** | **13.97684** |

### Comparison Example 1:

Use traditional phosphorus diffusion process to produce a set of solar cells with 5N purity silicon wafer.

Twelve (12) of said solar cells are randomly selected, the short circuit current Isc, open circuit voltage Voc, the maximum power Pmax, fill factor FF and photoelectric conversion efficiency EF are measured under conditions of AM1.5 and a temperature of 27 °C. The results are as shown in the table below:

| **No.** | **Isc(A)** | **Voc(mV)** | **Pmax(W)** | **FF(%)** | **EF(%)** |
|---|---|---|---|---|---|
| **1** | **3.92058** | **0.60462** | **0.84076** | **0.35468** | **5.65863** |
| **2** | **3.98012** | **0.61667** | **0.92812** | **0.37815** | **6.24662** |
| **3** | **3.97738** | **0.61748** | **0.97356** | **0.39641** | **6.55244** |
| **4** | **4.04155** | **0.61912** | **1.05359** | **0.42107** | **7.09106** |
| **5** | **4.23414** | **0.61565** | **1.13905** | **0.43696** | **7.66626** |
| **6** | **4.24061** | **0.62082** | **1.20179** | **0.45649** | **8.08848** |
| **7** | **4.38697** | **0.61601** | **1.31707** | **0.48737** | **8.86438** |
| **8** | **4.57012** | **0.61332** | **1.41021** | **0.50312** | **9.49122** |
| **9** | **4.62997** | **0.61498** | **1.49039** | **0.52343** | **10.03087** |
| **10** | **4.64822** | **0.61207** | **1.63927** | **0.57619** | **11.03289** |
| **11** | **4.59806** | **0.61483** | **1.79448** | **0.63476** | **12.07754** |
| **12** | **4.70738** | **0.6133** | **1.93556** | **0.67043** | **13.02708** |
| **Average** | **4.327925** | **0.614906** | **1.310321** | **0.486588** | **8.818956** |

From the above examples we can see that the solar cells produced from the three examples have more consistent performance, and the average conversion efficiency of these three batches of solar cells are respectively 13.77691%, 13.5848% and 13.97684%, while the performance of the solar cells produced in the comparing example fluctuate greatly, and its average conversion efficiency is only 8.818956%. Because of the bad consistency and low conversion efficiency of solar cells produce by means as in the comparing example, it cannot be used in the commercial applications.

Thus, the application of the technical solution in this invention can effectively utilize the mono-crystalline silicon wafers with lower purity to manufacture solar cells and thereby greatly reduce the manufacturing cost of solar cells.

## Claims

1. A process of phosphorus diffusion for manufacturing solar cell, comprising:
(1) annealing the mono-crystalline silicon wafer in a nitrogen atmosphere at 900∼950 °C for 20 to 30 minutes;
(2) carrying oxidation treatment in a hydrogen chloride atmosphere at 850 ∼ 1050 °C to form a 10 to 30 nm thick oxide layer on the surface of said silicon wafer;
(3) then diffusing from a phosphorus source at 850 ∼ 900 °C, till the block resistance of material surface is controlled at 40 to 50 ohms, and the junction depth is at 0.2 to 1.0 microns;
(4) finally, annealing in a nitrogen atmosphere at 700-750 °C for 30 to 60 minutes to complete the phosphorus diffusion of said mono-crystalline silicon wafer.

2. The process according to claim 1, wherein the duration of said oxidation treatment in step (2) is 20 to 30 minutes.

3. The process according to claim 1, wherein the duration for said diffusion from a phosphorus source in step (3) is 25 to 60 minutes.
